# EUROPÄISCHE PATENTSCHRIFT

(11) **EP 4 632 357 B1**
(45) Veröffentlichungstag und Bekanntmachung des Hinweises auf die Patenterteilung: **28.01.2026**
(21) Anmeldenummer: 24169574.1
(22) Anmeldetag: 11.04.2024
(51) Int. Cl.: G01N 21/65, G01J 3/44, G01N 21/05, H01S 5/14, G01N 21/39

(54) **ANALYSEVORRICHTUNG**
ANALYTICAL DEVICE
ANALYSEUR

(43) Veröffentlichungstag der Anmeldung: 15.10.2025
(73) Patentinhaber: Endress+Hauser SICK GmbH+Co. KG, 01458 Ottendorf-Okrilla (DE)
(72) Erfinder: Fimpel, Peter, 78462 Konstanz (DE); Loskill, Martin, 78464 Konstanz (DE)
(74) Vertreter: Manitz Finsterwald Patent- und Rechtsanwaltspartnerschaft mbB

(56) Entgegenhaltungen:
- CN-A- 109 557 075
- CN-U- 204 666 513
- US-A- 5 673 109
- US-A1- 2022 228 911
- CHU JOHNNY ET AL: "Advanced laser based spectroscopic techniques for trace gas detection based on optical cavity enhancement and multipass absorption cells", 2015, XP093178974, Retrieved from the Internet <URL:https://etheses.whiterose.ac.uk/13281/1/JCCL%20Final.pdf>
- FRUNDER H. ET AL: "CARS spectrometer with cw intra-cavity excitation for high-resolution Raman spectroscopy", JOURNAL OF RAMAN SPECTROSCOPY, vol. 17, no. 1, February 1986 (1986-02-01), GB, pages 143 - 150, XP093206230, ISSN: 0377-0486, DOI: 10.1002/jrs.1250170129

## Beschreibung

Die Erfindung betrifft eine Analysevorrichtung zum Analysieren einer Probensubstanz mittels Raman-Spektroskopie, mit einem Probenraum zur Aufnahme der Probensubstanz, einem Lasersystem zum Bestrahlen der in dem Probenraum befindlichen Probensubstanz mit Laserlicht, und einer Detektionseinheit zum Erzeugen eines Raman-Spektrums anhand von Streulicht, das von der Probensubstanz ausgeht, wobei das Lasersystem eine Laser-Einheit mit einer Lichtaustrittsfläche für den Austritt eines Laserstrahls und ein dispergierendes Element aufweist, das in einem Abstand zur Lichtaustrittsfläche derart angeordnet ist, dass es von dem Laserstrahl beaufschlagt wird und für eine Rückkopplung wenigstens einen Teil des Laserlichts in Richtung der Lichtaustrittsfläche zurücksendet.

Derartige Vorrichtungen werden beispielsweise zur berührungslosen Bestimmung der Konzentration einzelner Stoffe in Stoffgemischen eingesetzt. Bei der Probensubstanz kann es sich um ein Gas oder ein Gasgemisch handeln. Entsprechende Gasanalysevorrichtungen werden zum Beispiel bei der Überwachung industrieller Prozesse benötigt. Es sind aber auch Flüssigkeiten und Feststoffe mittels Raman-Spektroskopie analysierbar.

Bei der Raman-Spektroskopie wird die unelastische Streuung von Licht an Materie untersucht, indem das von einer Substanz gestreute Licht spektral ausgewertet wird. Die detektierten Frequenzverschiebungen gegenüber dem eingestrahlten Licht gehen auf quantisierte Rotations-, Schwingungs- und Rotations-Schwingungs-Übergänge zurück und sind für verschiedene Molekülarten charakteristisch. Demgemäß ermöglicht die Raman-Spektroskopie sowohl eine Strukturanalyse von Molekülen als auch einen qualitativen und quantitativen Substanznachweis.

Raman-Signale sind relativ schwach, so dass im Allgemeinen eine leistungsstarke Laser-Einheit bereitgestellt werden muss. Außerdem ist eine hohe spektrale Reinheit des Anregungslichts notwendig, um eine ausreichende spektrale Auflösung der Raman-Signale zu gewährleisten. Ein entsprechendes Lasersystem ist aber mit hohen Kosten verbunden und beansprucht viel Energie und Bauraum, was insbesondere bei industriell verwendbaren Analysevorrichtungen unerwünscht ist.

Das dispergierende Element ist in der Lage, die Linienbreite des Laserlichts zu verringern und das Laserlicht mit der verringerten Linienbreite zum Laser-Ausgang zurückzusenden. Zwischen der Lichtaustrittsfläche der Laser-Einheit und dem dispergierenden Element ist dann ein externer Resonator ausgebildet, welcher den Laserprozess stabilisiert und die Linienbreite insgesamt verringert. Durch den externen Resonator können die Anforderungen an die Laser-Einheit selbst gesenkt werden. Ein weiterer Vorteil des externen Resonators besteht darin, dass durch eine Positionsverstellung des dispergierenden Elements zumindest in einem begrenzten Umfang eine Durchstimmung der Wellenlänge des Laserlichts möglich ist.

Eine Analysevorrichtung, die auf Raman-Spektroskopie beruht und ein Lasersystem mit einer Laser-Einheit und mit einem dispergierenden Element zur Bildung eines externen Resonators aufweist, ist in der US 2022 / 0228911 A1 offenbart.

Die Druckschrift CN 109557075 A beschreibt eine Analysevorrichtung zum Analysieren einer Probensubstanz mittels Raman-Spektroskopie, bei der ein Probenraum für ein Probengas innerhalb eines externen Resonators in Littrow-Anordnung zwischen einem Halbleiterlaser und einem dispergierendem Gitter angeordnet ist.

Der externe Resonator beansprucht zusätzlichen Bauraum, der beispielsweise in Messgeräten oft nicht zur Verfügung steht. Außerdem erhöht das vorzusehende dispergierende Element die Herstellungskosten.

Es ist eine Aufgabe der Erfindung, eine Analysevorrichtung der vorstehend genannten Art anzugeben, die eine hohe Messempfindlichkeit und gleichzeitig einen einfachen und kompakten Aufbau aufweist.

Erfindungsgemäß ist der Probenraum zwischen der Laser-Einheit und dem dispergierenden Element angeordnet und die Detektionseinheit ist derart angeordnet, dass sie das von der Probensubstanz ausgehende Streulicht über das dispergierende Element empfängt.

Der Probenraum befindet sich also im externen Resonator des Lasersystems. Dies spart einerseits Bauraum und sorgt andererseits für eine besonders hohe Bestrahlungsleistung in der Probensubstanz, woraus sich ein stärkeres Nutzsignal ergibt. Da außerdem das dispergierende Element sowohl zur Rückkopplung des Laserlichts als auch zur spektralen Trennung der Raman-Signale dient, ergibt sich ein besonders kompakter Aufbau. Insbesondere kann gegenüber Systemen mit direktem Empfang des Streulichts vom Probenraum ein dispergierendes Element eingespart werden.

Vorzugsweise ist das dispergierende Element ein Beugungsgitter, beispielsweise ein Blazegitter. Beugungsgitter weisen eine hohe spektrale Trennschärfe auf. Je nach Anwendung kann das Beugungsgitter als Transmissionsgitter oder als Reflexionsgitter ausgeführt sein. Der Vorteil eines Transmissionsgitters besteht in einer besonders hohen Robustheit und Beugungseffizienz. Ein Reflexionsgitter ermöglicht hingegen eine spiegelfreie Rückkopplungs-Anordnung. Grundsätzlich könnte anstelle eines Beugungsgitters oder zusätzlich zum Beugungsgitter auch ein Prisma als dispergierendes Element vorgesehen sein.

Das Beugungsgitter kann mittels eines steuerbaren Antriebs um eine Rotationsachse drehbar sein. Eine Drehung oder Verkippung des Beugungsgitters bewirkt eine Änderung der Anregungswellenlänge und somit auch der Wellenlängen der Raman-Signale. Dies kann zur Erhöhung der spektralen Auflösung genutzt werden. Ein drehbares Beugungsgitter ermöglicht weiterhin die Verwendung eines Punktdetektors zur spektralen Analyse des Streulichts, weil die spektrale Information durch den Drehwinkel des Beugungsgitters gegeben ist. Vorzugsweise ist deshalb eine Gebervorrichtung zum Erfassen des aktuellen Drehwinkels vorgesehen. Punktdetektoren wie Photoelektronen-Vervielfacher (photomultiplier) oder Photonenzähler (photon counter) sind besonders empfindlich und ermöglichen die Detektion extrem geringer Lichtsignale. Eine spezielle Ausgestaltung der Erfindung sieht vor, dass die Detektionseinheit einen Silizium-Photomultiplier (SiPM) aufweist. Ferner kann die Detektionseinheit ein elektronisches Signalfiltermodul aufweisen, das für eine "lock-in"-Verstärkung oder für eine zeitkorrelierte Einzelphotonen-Detektion ausgebildet ist.

Grundsätzlich kann die Detektionseinheit eine Spektrometer-Anordnung aufweisen.

Gemäß einer Ausführungsform der Erfindung ist das Beugungsgitter derart angeordnet und ausgebildet, dass ein gebeugter Lichtstrahl, insbesondere der Lichtstrahl der ersten Beugungsordnung, vom Beugungsgitter in Richtung der Lichtaustrittsfläche zurückgesendet wird. Eine solche Anordnung, die auch Littrow-Anordnung genannt wird, ist besonders einfach realisierbar.

Ein erster Spiegel kann dazu vorgesehen sein, einen am Beugungsgitter reflektierten oder transmittierten Lichtstrahl wieder zurück zum Beugungsgitter zu reflektieren. Da sich der Probenraum innerhalb der Kavität des Lasersystems befindet, ist es nicht erforderlich, einen Nutzstrahl auszukoppeln. Somit kann die Bestrahlungsstärke im Probenraum durch die Rückreflexion des Strahls der 0. Beugungsordnung am ersten Spiegel erhöht werden.

Es kann auch ein zweiter Spiegel dazu vorgesehen sein, einen gebeugten Lichtstrahl wieder zurück zum Beugungsgitter zu reflektieren, um die Bestrahlungsstärke im Probenraum weiter zu verstärken.

Vorzugsweise ist die Laser-Einheit eine Laserdiode. Laserdioden sind besonders kompakt und kostengünstig. Sie eignen sich in besonderer Weise für eine Ergänzung durch einen externen Resonator. Das Lasersystem kann insbesondere als External Cavity Diode Laser (ECDL) ausgeführt sein.

Der Probenraum kann teilweise oder vollständig durch einen Behälter, insbesondere eine transparente Küvette, definiert sein. Je nach Anwendung könnte aber auch ein durchströmbarer Kanal den Probenraum bilden.

Gemäß einer speziellen Ausgestaltung der Erfindung ist der Probenraum teilweise oder vollständig durch einen Hohlraum eines lichtleitenden, vorzugsweise Mikrostrukturen aufweisenden Hohlfaser-Elements gebildet. Insbesondere kann eine so genannte Hollow-Core-Fiber oder Hohlkernfaser vorgesehen sein, welche wenigstens zum Teil mit der Probensubstanz gefüllt ist. Dies bewirkt eine weitere Verstärkung des Raman-Signals.

Die Detektionseinheit kann einen Lichtempfänger aufweisen, der wenigstens in einer Raumrichtung ortsauflösend ist. Dies ermöglicht eine gleichzeitige Erfassung unterschiedlicher Raman-Frequenzen, weil das dispergierende Element für eine Richtungsaufspaltung der einzelnen Signalkomponenten sorgt. Somit kann das Raman-Spektrum besonders schnell und einfach erstellt werden. Bei dem ortsauflösenden Lichtempfänger kann es sich beispielsweise um einen CCD-Sensor handeln.

Zwischen dem dispergierenden Element und der Detektionseinheit kann eine Abbildungsoptik zum Abbilden des dispergierten Lichts auf den ortsauflösenden Lichtempfänger angeordnet sein, um eine optimale Trennung der einzelnen Raman-Linien zu erzielen.

Eine weitere Ausführungsform der Erfindung sieht vor, dass zwischen der Lichtaustrittsfläche und dem Probenraum eine Fokussierungslinse zum Fokussieren des Laserlichts in dem Probenraum angeordnet ist und zwischen dem Probenraum und dem dispergierenden Element eine Kollimationslinse zum Parallelrichten des fokussierten Laserlichts angeordnet ist. Hierdurch wird ein Zwischenfokus im Probenraum erzeugt, in welchem eine besonders hohe Lichtintensität vorliegt.

Zwischen der Lichtaustrittsfläche und dem Probenraum kann ein Bandpassfilter angeordnet sein, dessen Durchlässigkeitsbereich an eine Emissionswellenlänge der Laser-Einheit angepasst ist. Ein solcher Reinigungsfilter oder "clean-up"-Filter verhindert, dass in nennenswertem Umfang von der Laser-Einheit ausgehendes Störlicht detektiert wird.

Weiterbildungen der Erfindung sind auch den abhängigen Ansprüchen, der Beschreibung sowie den beigefügten Zeichnungen zu entnehmen.

Die Erfindung wird nachfolgend beispielhaft anhand der schematischen Zeichnungen beschrieben.
- Fig. 1: ist eine vereinfachte Draufsicht auf eine Analysevorrichtung gemäß einer ersten Ausführungsform der Erfindung.
- Fig. 2: zeigt eine Analysevorrichtung gemäß einer zweiten Ausführungsform der Erfindung.
- Fig. 3: zeigt eine Analysevorrichtung gemäß einer dritten Ausführungsform der Erfindung.
- Fig. 4: zeigt eine Analysevorrichtung gemäß einer vierten Ausführungsform der Erfindung.

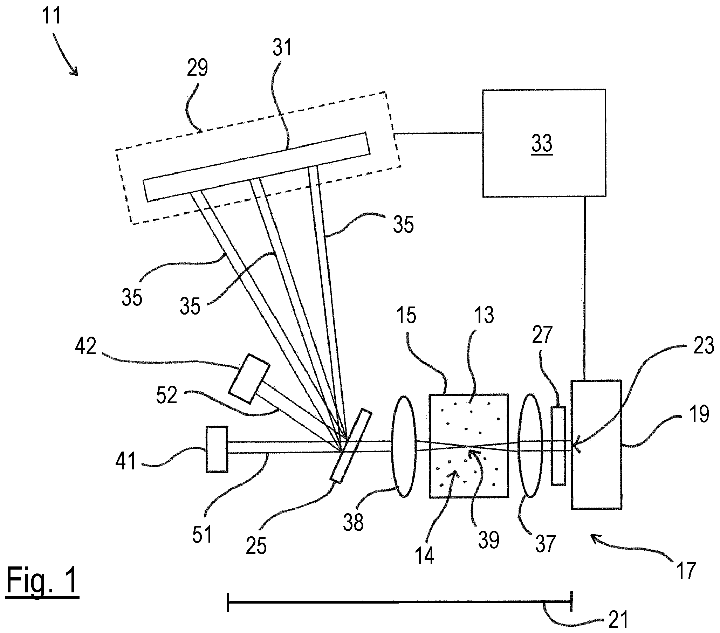

Die in Fig. 1 dargestellte Analysevorrichtung 11 dient zum Analysieren einer gasförmigen oder flüssigen Probensubstanz 13 mittels Raman-Spektroskopie. Die Probensubstanz 13 befindet sich in einem Probenraum 14, der hier durch einen transparenten Behälter 15 wie zum Beispiel eine Glasküvette definiert ist. Zum Bestrahlen der in dem Behälter 15 befindlichen Probensubstanz 13 mit Laserlicht ist ein Lasersystem 17 vorgesehen, das eine Laser-Einheit 19 sowie einen externen Resonator 21 umfasst. Bei der Laser-Einheit 19 handelt es sich bevorzugt um eine Laserdiode. Der externe Resonator 21 ist durch eine Lichtaustrittsfläche 23 der Laser-Einheit 19 und wenigstens durch einen ersten Spiegel 41 begrenzt. Weiterhin ist in dem externen Resonator 21 ein Beugungsgitter 25 vorgesehen. Bei der in Fig. 1 gezeigten Ausführungsform ist das Beugungsgitter 25 ein Transmissionsgitter. Der erste Spiegel 41 reflektiert den vom Beugungsgitter 25 transmittierten Lichtstrahl 51 der 0. Beugungsordnung wieder zurück zum Beugungsgitter 25 und in den Probenraum 14.

Das Beugungsgitter 25 bewirkt eine spektral selektive Rückkopplung von Laserlicht in Richtung der Lichtaustrittsfläche 23, was mit einer Verringerung der Linienbreite des Lasersystems 17 einhergeht. Konkret bildet die Anordnung aus der Laser-Einheit 19 und dem Beugungsgitter 25 eine External Cavity Laser Diode (ECDL). Um Störlicht zu blockieren, ist im Bereich der Lichtaustrittsfläche 23 ein Bandpassfilter 27 angeordnet, der ausschließlich für Licht einer gewünschten Anregungswellenlänge durchlässig ist.

Die Analysevorrichtung 11 weist ferner eine Detektionseinheit 29 auf, die einen ortsauflösenden Lichtempfänger 31 umfasst und zum Erzeugen eines Raman-Spektrums anhand von Streulicht der Probensubstanz 13 ausgelegt ist. Die Detektionseinheit 29 steht mit einer elektronischen Auswertungseinheit 33 in Signalverbindung. Die elektronische Auswertungseinheit 33 ist dazu ausgebildet, anhand des Raman-Spektrums die Konzentration wenigstens eines Stoffs in der Probensubstanz 13 zu bestimmen und vorzugsweise auf einer nicht dargestellten Anzeigevorrichtung anzuzeigen.

Wie gezeigt ist die Detektionseinheit 29 derart angeordnet, dass dasjenige von dem Beugungsgitter 25 gebeugte Licht, das Raman-Signalen 35 entspricht, auf den ortsauflösenden Lichtempfänger 31 auftrifft. Das von der Probensubstanz 13 ausgehende Streulicht wird also nicht direkt empfangen, sondern über das Beugungsgitter 25. Somit ist es nicht erforderlich, die Detektionseinheit 29 mit einem eigenen Beugungsgitter auszustatten. Möglich ist der Empfang über das Beugungsgitter 25 insbesondere dadurch, dass der Probenraum 14 zwischen der Laser-Einheit 19 und dem Beugungsgitter 25, also innerhalb des externen Resonators 21, angeordnet ist.

Um die Lichtintensität im Probenraum 14 zu erhöhen, wird mittels einer Fokussierungslinse 37 und einer Kollimationslinse 38 ein Zwischenfokus 39 im Probenraum 14 erzeugt. Die Fokussierungslinse 37 befindet sich zwischen der Lichtaustrittsfläche 23 und dem Probenraum 14, während die Kollimationslinse 38 zwischen dem Probenraum 14 und dem Beugungsgitter 25 angeordnet ist.

Eine weitere Maßnahme zum Erhöhen der Lichtintensität im Probenraum 14 besteht darin, mittels eines zweiten Spiegels 42 den am Beugungsgitter 25 gebeugten Lichtstrahl 52 der 1. Beugungsordnung wieder zurück zum Beugungsgitter 25 zu reflektieren, um so einen Wiedereintritt in den Probenraum 14 zu bewirken.

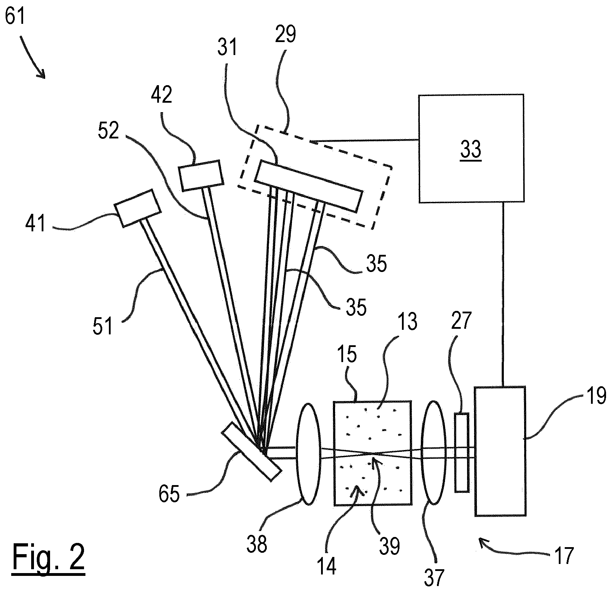

Fig. 2 zeigt eine alternative Ausführungsform einer erfindungsgemäßen Analysevorrichtung 61, welche im Wesentlichen so gestaltet ist wie die Analysevorrichtung 11 gemäß Fig. 1, im Unterschied hierzu jedoch ein Beugungsgitter 65 aufweist, das als Reflexionsgitter und nicht als Transmissionsgitter ausgeführt ist. Dementsprechend sind die beiden Spiegel 41, 42 nicht hinter dem Beugungsgitter 65 angeordnet, sondern seitlich versetzt zu diesem. Im Übrigen entsprechen die in Fig. 2 verwendeten Bezugszeichen denjenigen der Fig. 1.

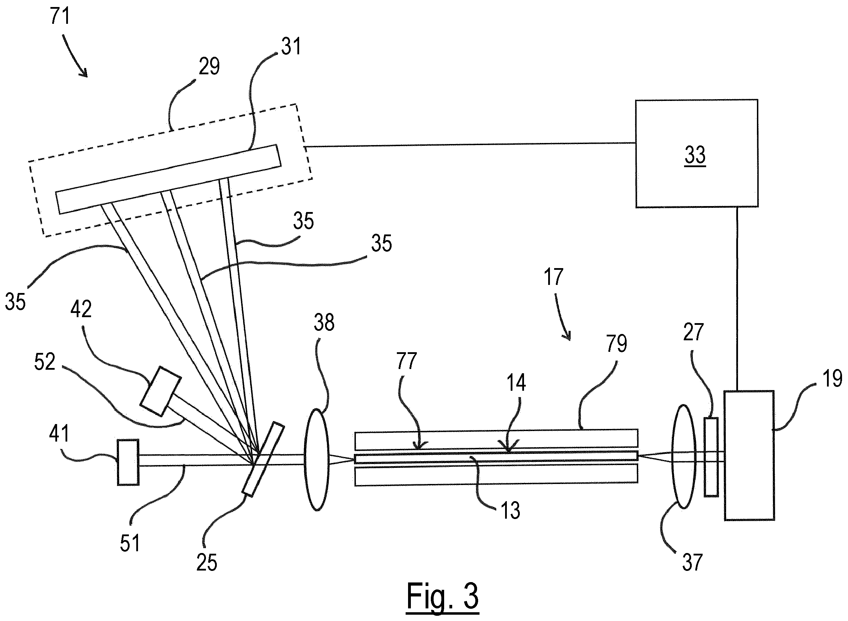

In Fig. 3 ist eine Ausführungsform einer erfindungsgemäßen Analysevorrichtung 71 dargestellt, die im Wesentlichen so gestaltet ist wie die Analysevorrichtung 11 gemäß Fig. 1 und die insbesondere ein als Transmissionsgitter ausgeführtes Beugungsgitter 25 aufweist. Im Unterschied zur Ausführungsform gemäß Fig. 1 ist jedoch der Probenraum 14 in einem Hohlraum 77 eines lichtleitenden Hohlfaser-Elements 79 angeordnet. Ein separater Behälter 15 für die Probensubstanz 13 ist bei dieser Variante nicht erforderlich.

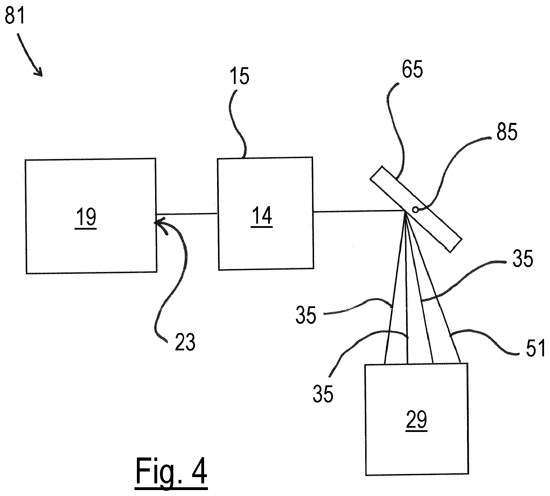

Ein als Reflexionsgitter ausgeführtes Beugungsgitter 65 wie in Fig. 2 gezeigt kann auch so positioniert werden, dass eine Littrow-Anordnung vorliegt. Eine entsprechende Analysevorrichtung 81, bei welcher kein Spiegel vorgesehen ist, ist in Fig. 4 dargestellt. Weiterhin ist in Fig. 4 eine Rotationsachse 85 gezeigt, um welche das Beugungsgitter 65 mittels eines nicht dargestellten Antriebs drehbar ist. Somit kann die Rückkopplung derart beeinflusst werden, dass sich die Anregungswellenlänge ändert, wodurch sich auch die Raman-Signale ändern. Ein steuerbarer Antrieb zum Drehen oder Verkippen des Beugungsgitters 25, 65 kann im Übrigen auch bei den zuvor beschriebenen Ausführungsformen vorgesehen sein.

Indem das Beugungsgitter 25, 65 sowohl zur spektralen Rückkopplung im Lasersystem 17 als auch zur spektralen Aufspaltung des zu detektierenden Streulichts verwendet wird, können die Herstellungskosten gering gehalten werden. Die Anordnung des Probenraums 14 im externen Resonator erlaubt ferner einen besonders kompakten Aufbau. Grundsätzlich könnte anstelle eines Beugungsgitters 25, 65 auch ein Prisma oder ein anderes dispergierendes Element vorgesehen sein.

### Bezugszeichenliste:

- 11: Analysevorrichtung
- 13: Probensubstanz
- 14: Probenraum
- 15: Behälter
- 17: Lasersystem
- 19: Laser-Einheit
- 21: externer Resonator
- 23: Lichtaustrittsfläche
- 25: Beugungsgitter
- 27: Bandpassfilter
- 29: Detektionseinheit
- 31: ortsauflösender Lichtempfänger
- 33: elektronische Auswertungseinheit
- 35: Raman-Signal
- 37: Fokussierungslinse
- 38: Kollimationslinse
- 39: Zwischenfokus
- 41: erster Spiegel
- 42: zweiter Spiegel
- 51: Lichtstrahl nullter Beugungsordnung
- 52: Lichtstrahl erster Beugungsordnung
- 61: Analysevorrichtung
- 65: Beugungsgitter
- 71: Analysevorrichtung
- 77: Hohlraum
- 79: Hohlfaser-Element
- 81: Analysevorrichtung
- 85: Rotationsachse

## Patentansprüche

1. Analysevorrichtung (11, 61, 71, 81) zum Analysieren einer Probensubstanz (13) mittels Raman-Spektroskopie,
mit einem Probenraum (14) zur Aufnahme der Probensubstanz (13), einem Lasersystem (17) zum Bestrahlen der in dem Probenraum (14) befindlichen Probensubstanz (13) mit Laserlicht, und
einer Detektionseinheit (29) zum Erzeugen eines Raman-Spektrums anhand von Streulicht, das von der Probensubstanz (13) ausgeht,
wobei das Lasersystem (17) eine Laser-Einheit (19) mit einer Lichtaustrittsfläche (23) für den Austritt eines Laserstrahls und ein dispergierendes Element (25, 65) aufweist, das in einem Abstand zur Lichtaustrittsfläche (23) derart angeordnet ist, dass es von dem Laserstrahl beaufschlagt wird und für eine Rückkopplung wenigstens einen Teil des Laserlichts in Richtung der Lichtaustrittsfläche (23) zurücksendet,
wobei der Probenraum (14) zwischen der Laser-Einheit (19) und dem dispergierenden Element (25, 65) angeordnet ist und die Detektionseinheit (29) derart angeordnet ist, dass sie das von der Probensubstanz (13) ausgehende Streulicht über das dispergierende Element (25, 65) empfängt.

2. Analysevorrichtung nach Anspruch 1,
wobei das dispergierende Element (25, 65) ein Beugungsgitter ist.

3. Analysevorrichtung nach Anspruch 2,
wobei das Beugungsgitter (25, 65) mittels eines steuerbaren Antriebs um eine Rotationsachse (85) drehbar ist.

4. Analysevorrichtung nach Anspruch 2 oder 3,
wobei das Beugungsgitter (25, 65) derart angeordnet und ausgebildet ist, dass ein gebeugter Lichtstrahl, insbesondere der Lichtstrahl der ersten Beugungsordnung, vom Beugungsgitter (25, 65) in Richtung der Lichtaustrittsfläche (23) zurückgesendet wird.

5. Analysevorrichtung nach einem der Ansprüche 2 bis 4,
wobei ein erster Spiegel (41) dazu vorgesehen ist, einen am Beugungsgitter (25, 65) reflektierten oder transmittierten Lichtstrahl (51) wieder zurück zum Beugungsgitter (25, 65) zu reflektieren.

6. Analysevorrichtung nach Anspruch 5,
wobei ein zweiter Spiegel (42) dazu vorgesehen ist, einen gebeugten Lichtstrahl (52) wieder zurück zum Beugungsgitter (25, 65) zu reflektieren.

7. Analysevorrichtung nach einem der vorstehenden Ansprüche,
wobei die Laser-Einheit (19) eine Laserdiode ist.

8. Analysevorrichtung nach einem der vorstehenden Ansprüche,
wobei der Probenraum (14) teilweise oder vollständig durch einen Behälter (15), insbesondere eine transparente Küvette, definiert ist.

9. Analysevorrichtung nach einem der vorstehenden Ansprüche,
wobei der Probenraum (14) teilweise oder vollständig durch einen Hohlraum (77) eines lichtleitenden Hohlfaser-Elements (79) gebildet ist.

10. Analysevorrichtung nach einem der vorstehenden Ansprüche,
wobei die Detektionseinheit (29) einen Lichtempfänger (31) aufweist, der wenigstens in einer Raumrichtung ortsauflösend ist.

11. Analysevorrichtung nach Anspruch 10,
wobei zwischen dem dispergierenden Element (25, 65) und der Detektionseinheit (29) eine Abbildungsoptik zum Abbilden des dispergierten Lichts auf den ortsauflösenden Lichtempfänger (31) angeordnet ist.

12. Analysevorrichtung nach einem der vorstehenden Ansprüche,
wobei zwischen der Lichtaustrittsfläche (23) und dem Probenraum (14) eine Fokussierungslinse (37) zum Fokussieren des Laserlichts in dem Probenraum (14) angeordnet ist und
zwischen dem Probenraum (14) und dem dispergierenden Element (25, 65) eine Kollimationslinse (38) zum Parallelrichten des fokussierten Laserlichts angeordnet ist.

13. Analysevorrichtung nach einem der vorstehenden Ansprüche,
wobei zwischen der Lichtaustrittsfläche (23) und dem Probenraum (14) ein Bandpassfilter (27) angeordnet ist, dessen Durchlässigkeitsbereich an eine Emissionswellenlänge der Laser-Einheit (19) angepasst ist.

## Claims

1. An analysis apparatus (11, 61, 71, 81) for analyzing a sample substance (13) by means of Raman spectroscopy, said analysis apparatus (11, 61, 71, 81) comprising
a sample space (14) for receiving the sample substance (13),
a laser system (17) for irradiating the sample substance (13) located in the sample space (14) with laser light, and
a detection unit (29) for generating a Raman spectrum using scattered light which emanates from the sample substance (13),
wherein the laser system (17) has a laser unit (19) comprising a light exit surface (23) for the exit of a laser beam and a dispersing element (25, 65) which is arranged at a spacing from the light exit surface (23) such that said dispersing element (25, 65) is acted on by the laser beam and transmits at least a portion of the laser light towards the light exit surface (23) for a feedback,
wherein the sample space (14) is arranged between the laser unit (19) and the dispersing element (25, 65) and the detection unit (29) is arranged such that it receives the scattered light emanating from the sample substance (13) via the dispersing element (25, 65).

2. An analysis apparatus according to claim 1,
wherein the dispersing element (25, 65) is a diffraction grating.

3. An analysis apparatus according to claim 2,
wherein the diffraction grating (25, 65) can be rotated about an axis of rotation (85) by means of a controllable drive.

4. An analysis apparatus according to claim 2 or 3,
wherein the diffraction grating (25, 65) is arranged and formed such that a diffracted light beam, in particular the light beam of the first order of diffraction, is transmitted from the diffraction grating (25, 65) back towards the light exit surface (23).

5. An analysis apparatus according to any one of the claims 2 to 4,
wherein a first mirror (41) is provided to reflect a light beam (51) reflected or transmitted at the diffraction grating (25, 65) back to the diffraction grating (25, 65) again.

6. An analysis apparatus according to claim 5,
wherein a second mirror (42) is provided to reflect a diffracted light beam (52) back to the diffraction grating (25, 65) again.

7. An analysis apparatus according to any one of the preceding claims, wherein the laser unit (19) is a laser diode.

8. An analysis apparatus according to any one of the preceding claims, wherein the sample space (14) is partly or completely defined by a container (15), in particular a transparent cuvette.

9. An analysis apparatus according to any one of the preceding claims, wherein the sample space (14) is partly or completely formed by a cavity (77) of a light-conducting hollow fiber element (79).

10. An analysis apparatus according to any one of the preceding claims, wherein the detection unit (29) has a light receiver (31) which is spatially resolving in at least one spatial direction.

11. An analysis apparatus according to claim 10,
wherein an imaging optics for imaging the dispersed light onto the spatially resolving light receiver (31) is arranged between the dispersing element (25, 65) and the detection unit (29).

12. An analysis apparatus according to any one of the preceding claims,
wherein a focusing lens (37) for focusing the laser light in the sample space (14) is arranged between the light exit surface (23) and the sample space (14), and
a collimation lens (38) for collimating the focused laser light is arranged between the sample space (14) and the dispersing element (25, 65).

13. An analysis apparatus according to any one of the preceding claims, wherein a bandpass filter (27), whose transmission range is adapted to an emission wavelength of the laser unit (19), is arranged between the light exit surface (23) and the sample space (14).

## Revendications

1. Dispositif d'analyse (11, 61, 71, 81) pour analyser une substance échantillon (13) au moyen de la spectroscopie Raman, comprenant
une chambre d'échantillonnage (14) pour recevoir la substance échantillon (13),
un système laser (17) pour irradier la substance échantillon (13), située dans la chambre d'échantillonnage (14), avec une lumière laser, et
une unité de détection (29) pour générer un spectre Raman à partir de la lumière diffusée émise par la substance échantillon (13),
dans lequel
le système laser (17) comprend une unité laser (19) présentant une surface de sortie de lumière (23) pour la sortie d'un faisceau laser et un élément dispersant (25, 65) qui est disposé à une certaine distance de la surface de sortie de lumière (23) de telle sorte qu'il est exposé au faisceau laser et renvoie au moins une partie de la lumière laser vers la surface de sortie de lumière (23) pour une rétroaction,
la chambre d'échantillonnage (14) est disposée entre l'unité laser (19) et l'élément dispersant (25, 65), et l'unité de détection (29) est disposée de manière à recevoir la lumière diffusée, émise par la substance échantillon (13), via l'élément dispersant (25, 65).

2. Dispositif d'analyse selon la revendication 1,
dans lequel l'élément dispersant (25, 65) est un réseau de diffraction.

3. Dispositif d'analyse selon la revendication 2,
dans lequel le réseau de diffraction (25, 65) peut tourner autour d'un axe de rotation (85) au moyen d'un entraînement commandable.

4. Dispositif d'analyse selon la revendication 2 ou 3,
dans lequel le réseau de diffraction (25, 65) est disposé et conçu de telle sorte qu'un faisceau lumineux diffracté, en particulier le faisceau lumineux du premier ordre de diffraction, est renvoyé par le réseau de diffraction (25, 65) en direction de la surface de sortie de lumière (23).

5. Dispositif d'analyse selon l'une des revendications 2 à 4,
dans lequel un premier miroir (41) est prévu pour réfléchir un faisceau lumineux (51), transmis ou réfléchi par le réseau de diffraction (25, 65), en retour vers le réseau de diffraction (25, 65).

6. Dispositif d'analyse selon la revendication 5,
dans lequel un deuxième miroir (42) est prévu pour réfléchir un faisceau lumineux diffracté (52) en retour vers le réseau de diffraction (25, 65).

7. Dispositif d'analyse selon l'une des revendications précédentes,
dans lequel l'unité laser (19) est une diode laser.

8. Dispositif d'analyse selon l'une des revendications précédentes,
dans lequel la chambre d'échantillonnage (14) est définie en partie ou en totalité par un récipient (15), en particulier par une cuvette transparente.

9. Dispositif d'analyse selon l'une des revendications précédentes,
dans lequel la chambre d'échantillonnage (14) est formée en partie ou en totalité par une cavité (77) d'un élément à fibre creuse conductrice de lumière (79).

10. Dispositif d'analyse selon l'une des revendications précédentes,
dans lequel l'unité de détection (29) comprend un récepteur de lumière (31) qui est à résolution spatiale dans au moins une direction dans l'espace.

11. Dispositif d'analyse selon la revendication 10,
dans lequel une optique de reproduction est disposée entre l'élément dispersant (25, 65) et l'unité de détection (29) pour reproduire la lumière dispersée sur le récepteur de lumière à résolution spatiale (31).

12. Dispositif d'analyse selon l'une des revendications précédentes,
dans lequel une lentille de focalisation (37) est disposée entre la surface de sortie de lumière (23) et la chambre d'échantillonnage (14) pour focaliser la lumière laser dans la chambre d'échantillonnage (14), et
une lentille de collimation (38) est disposée entre la chambre d'échantillonnage (14) et l'élément dispersant (25, 65) pour rendre parallèle la lumière laser focalisée.

13. Dispositif d'analyse selon l'une des revendications précédentes,
dans lequel un filtre passe-bande (27) est disposé entre la surface de sortie de lumière (23) et la chambre d'échantillonnage (14), dont la plage de transmission est adaptée à une longueur d'onde d'émission de l'unité laser (19).
